# EUROPÄISCHE PATENTSCHRIFT

(11) **EP 0 736 775 B1**
(45) Veröffentlichungstag und Bekanntmachung des Hinweises auf die Patenterteilung: **03.11.2004**
(21) Anmeldenummer: 96200860.3
(22) Anmeldetag: 29.03.1996
(51) Int. Cl.: G01R 31/04, H04R 29/00

(54) **Schaltungsanordnung zum Prüfen des Anschlusses einer Tonwiedergabevorrichtung an eine Tonsignalquelle**
Circuit for testing the connection of a reproduction set to a source of audio signals
Circuit pour tester la connexion d'un dispositif de reproduction sonore aux sources de reproduction sonore

(30) Priorität: 07.04.1995 DE 19513066
(43) Veröffentlichungstag der Anmeldung: 09.10.1996
(73) Patentinhaber: SIEMENS AKTIENGESELLSCHAFT, 80333 München (DE)
(72) Erfinder: Lünter, Heinz, Röntgenstrasse 24, 22335 Hamburg (DE)

(56) Entgegenhaltungen:
- DE-A- 4 423 362

## Beschreibung

Die Erfindung bezieht sich auf eine Schaltungsanordnung zum Prüfen des Anschlusses einer Tonwiedergabevorrichtung an eine Tonsignalquelle. Insbesondere bezieht sich die Erfindung auf eine solche Schaltungsanordnung zum Einsatz in einem Tonwiedergabegerät in einem Fahrzeug, beispielsweise einem Autoradio.

Bei derartigen Verbindungen zwischen Tonsignalquellen und Tonwiedergabevorrichtungen kann je nach Gestaltung des Aufbaus das Auffinden von Fehlerursachen bei Betriebsstörungen schwierig sein. Beispielsweise kann ein verdeckter Einbau derartiger Geräte für ein schnelles Auffinden der Fehlerquellen hinderlich sein. Insbesondere bei komplizierten Geräten mit einer hohen Anzahl möglicher Fehlerquellen kann sich dadurch die Fehlersuche und -beseitigung als sehr aufwendig erweisen.

Aus der DE-A-44 23 362 ist ein Prüfgerät für Kopfhörer einer Kopfanordnung bekannt, mit dem die Impedanz geprüft werden kann.

Die Erfindung hat die Aufgabe eine Schaltungsanordnung zum Prüfen des Anschlusses einer Tonwiedergabevorrichtung an eine Tonsignalquelle zu schaffen, durch die die Prüfung der Beschaffenheit dieser Verbindung in einfacher und schneller Weise möglich ist.

Diese Aufgabe wird erfindungsgemäß gelöst durch eine Schaltungsanordnung zum Prüfen des Anschlusses einer Tonwiedergabevorrichtung an eine Tonsignalquelle, der über eine Impedanz eine Versorgungsspannung aus einer Spannungsversorgung zuführbar ist und an die die Tonwiedergabevorrichtung angeschlossen ist, mit
- einer Leistungseinstelleinrichtung zum Einstellen der von der Tonsignalquelle an die Tonwiedergabevorrichtung abzugebenden Tonsignalleistung,
- einer Spannungsmeßeinrichtung zur Messung der von der Spannungsversorgung über die Impedanz gelieferten Versorgungsspannung in Abhängigkeit von der Tonsignalleistung, auf die die Tonsignalquelle eingestellt ist,
- und einer Vergleichseinrichtung zum Vergleichen der gemessenen Werte der Versorgungsspannung für zwei verschiedenen vorgegebene Werte der Tonsignalleistung und zum Abgeben eines Fehlersignals, falls die gemessenen Werte der Versorgungsspannung nicht um einen vorgegebenen Betrag voneinander abweichen.

Die Erfindung ermöglicht eine gezielte Fehlerdiagnose des Anschlusses einer Tonwiedergabevorrichtung an eine Tonsignalquelle ohne zusätzliche Prüfmittel. Eine derartige Fehlerdiagnose kann in sehr einfacher Weise zum Beispiel ohne Prüfgeräte auch von einem nicht versierten Benutzer vorgenommen werden. Dieser Benutzer ist dadurch in die Lage versetzt, das Gerät schnell und präzise auf bestimmte Fehlerursachen hin zu überprüfen, ohne dafür beispielsweise Einrichtungen und Personal einer Fachwerkstatt hinzuziehen zu müssen. Zusätzlich wird auch in einem solchen Fall für das Fachpersonal die Fehlersuche vereinfacht, was insgesamt zu einer erheblichen Verringerung von Wartungs- und Reparaturkosten führt.

Die Erfindung macht sich in vorteilhafter Weise die Erkenntnis zunutze, daß der von der Tonsignalquelle aus der Spannungsversorgung zu entnehmende Strom mit steigender Tonsignalleistung zunimmt und an der Impedanz, über die die Versorgungsspannung von der Spannungsversorgung an die Tonsignalquelle geliefert wird, eine zunehmende Spannung verursacht. Der Strom und die durch ihn verursachte Spannung bleiben jedoch aus, wenn die Tonwiedergabevorrichtung nicht an die Tonsignalquelle angeschlossen ist. Damit können Unterbrechungen des Anschlusses zwischen diesen beiden Teilen der angesprochenen Geräte einfach detektiert werden. Umgekehrt wird im Falle eines Kurzschlusses im Bereich des Anschlusses zwischen der Tonwiedergabevorrichtung und der Tonsignalquelle von der Spannungsversorgung ein übermäßig hoher Strom geliefert werden müssen, der ebenfalls zu einer vom vorgegebenen Betrag abweichenden Spannung führt. Damit lassen sich auch Kurzschlüsse oder vergleichbare Fehler detektieren.

Die angesprochene Impedanz muß dabei nicht gesondert in die Verbindung von der Spannungsversorgung zur Tonsignalquelle eingefügt werden. Vielmehr genügt dafür ein ohnehin vorhandener Glättungskreis für die Versorgungsspannung oder ein bei realen Spannungsversorgungen stets vorhandener, endlicher Innenwiderstand.

Gemäß der Erfindung ist die zum Prüfen des besagten Anschlusses vorgesehene Schaltungsanordnüng für eine Vergleichsmessung eingerichtet, durch die Schwankungen der Absolutwerte beispielsweise der von der Spannungsversorgung bereitgestellten Spannung eliminiert werden. Dadurch ist eine sehr feine und präzise Detektion auch geringer Spannungsänderungen der Versorgungsspannung möglich.

In einer vorteilhaften Ausgestaltung der erfindungsgemäßen Schaltungsanordnung sind die Leistungseinstelleinrichtung, die Spannungsmeßeinrichtung und die Vergleichseinrichtung als Teile einer Steuerschaltung für die Steuerung des Betriebs der Tonsignalquelle ausgebildet. Vorzugsweise kann diese Steuerung als digitale Steuerung mit einem Microprozessor ausgeführt werden. Dadurch wird der Schaltungsaufwand für die Erfindung in sehr engen Grenzen gehalten.

Insbesondere kann auch die Leistungseinstelleinrichtung durch einen in der Steuerschaltung vorhandenen Lautstärkesteller gebildet sein, so daß auch hierfür kein zusätzlicher Schaltungsaufwand entsteht. Die Durchführung der Prüfung erfolgt beispielsweise mit einer zusätzlichen Ablaufsteuerung, die im Microprozessor eingebunden ist. Damit können die Betriebssteuerung für den bestimmungsgemäßen Betrieb der Tonwiedergabevorrichtung und der Tonsignalquelle und die Steuerung für die Prüfung ein gemeinsames Bauteil bilden.

In einer Weiterbildung der Erfindung kann eine Einrichtung zum Abgeben des Fehlersignals als akustisches Signal vorgesehen sein, die insbesondere eine Summeranordnung umfaßt. Mit einer derartigen Summeranordnung oder einer vergleichbaren Einrichtung zum Abgeben eines akustischen Signals kann unabhängig von den zu prüfenden Tonwiedergabevorrichtungen, d.h. auch für den Fall, daß diese fehlerhaft nicht angeschlossen sind, ein einfaches Fehlersignal ausgegeben werden. Eine andere Möglichkeit zur Ausgabe des Fehlersignals besteht in einer optischen Anzeige, beispielsweise auf einer für die Anzeige von Betriebsparametern der Tonsignalquelle ohnehin vorhandenen Anzeigevorrichtung.

In einer anderen Ausgestaltung der Erfindung umfaßt diese eine Prüftonquelle zum Einspeisen einer Prüfschwingung in die Tonsignalquelle und ist von der Tonsignalquelle für die Messung der Versorgungsspannung ein auf der Prüfschwingung beruhendes Tonsignal mit einer vorgebbaren Tonsignalleistung an die Tonwiedergabeeinrichtung abgebbar. Gegenüber einer Prüfung mit Hilfe eines von der Tonsignalquelle beispielsweise auf Grundlage eines über eine Antenne empfangenen Rundfunksignals zu erzeugenden Prüfsignals besteht bei dieser Ausgestaltung der Erfindung der Vorteil einer definierten Grundlage für die durchzuführende Prüfung, da aktuelle, nicht vorhersehbare Schwankungen von der Tonsignalquelle gelieferter Signale ausgeschlossen werden können. Zur vorteilhaften Verminderung des Schaltungsaufwandes trägt dann eine Weiterbildung in der Weise bei, daß die Prüftonquelle von der Einrichtung zum Abgeben des Fehlersignals als akustisches Signal umfaßt ist. Dadurch kann die Prüftonquelle nämlich einerseits zur Erzeugung der Prüfschwingung und andererseits zum Erzeugen des Fehlersignals ausgenutzt werden.

In einer weiteren Ausgestaltung umfaßt die Tonwiedergabevorrichtung wenigstens einen Lautsprecher und ist die Messung der Versorgungsspannung für jeden Lautsprecher gesondert vornehmbar. Damit ist eine gezielte Prüfung für umfangreichere Tonwiedergabevorrichtungen, insbesondere Stereoanlagen in Kraftfahrzeugen, möglich, da diese oft mit einer Mehrzahl von Lautsprechern ausgerüstet sind. Vorteilhaft ist dabei die Ablaufsteuerung für das Prüfen der einzelnen Lautsprecher mit Balance- und/oder Überblendreglern gekoppelt.

Ein Ausführungsbeispiel ist in der Zeichnungd dargestellt und wird im nachfolgenden näher beschrieben. Es zeigen:
Fig. 1 eine blockschematisch dargestellte Schaltungsanordnung mit einer Tonsignalquelle und einer Tonwiedergabevorrichtung in erfindungsgemäßer Ausgestaltung,
Fig. 2 eine detailliertere, blockschematische Darstellung zu Fig. 1

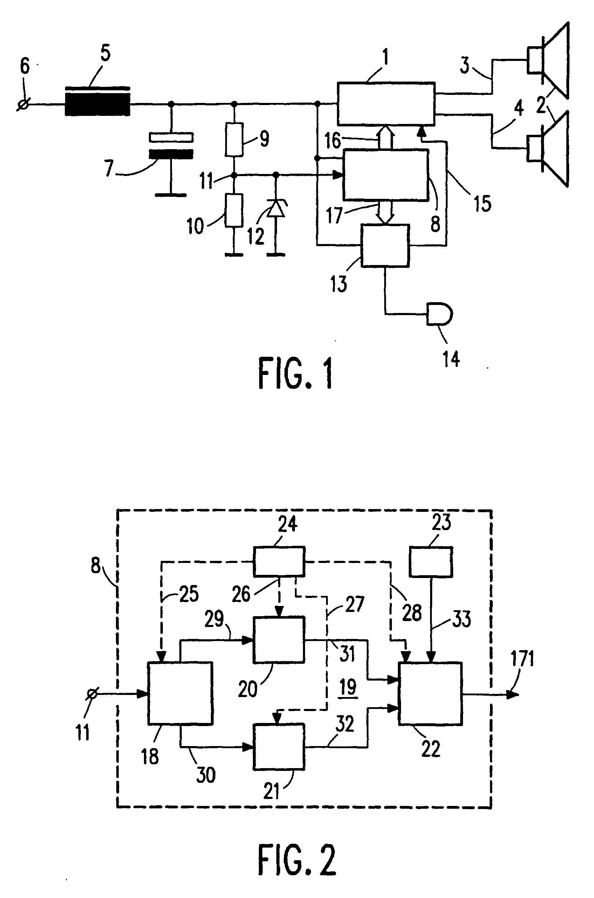

Fig. 1 zeigt eine Tonsignalquelle 1, an die zwei eine Tonwiedergabevorrichtung 2 bildende Lautsprecher angeschlossen sind. Über diesen im vorliegenden Beispiel aus zwei Lautsprecherleitungen 3, 4 bestehenden Anschluß wird Tonsignalleistung von der Tonsignalquelle 1 an die Tonwiedergabevorrichtung 2 übertragen. Zur Speisung der Tonsignalquelle mit Energie aus einer Spannungsversorgung ist die Tonsignalquelle 1 weiterhin über eine Impedanz 5 mit einem Spannungsversorgungsanschluß 6 verbunden. An diesem Spannungsversorgungsanschluß 6 kann eine in Fig. 1 nicht dargestellte Spannungsversorgung angeschlossen werden, die der Tonsignalquelle 1 eine Versorgungsspannung liefert. Beispielsweise handelt es sich bei einer derartigen Spannungsversorgung um ein Netzgerät, einen Kraftfahrzeugakkumulator oder dergleichen. Im gezeigten Beispiel ist die Impedanz 5 als Glättungsinduktivität ausgeführt, die in der Regel mit einem bestimmten ohmschen Widerstand behaftet ist. Zu der Impedanz 5 kann außerdem ein Innenwiderstand der nicht dargestellten Spannungsversorgung zählen. Dargestellt ist ferner ein Glättungskondensator 7, der von einem dem Spannungsversorgungsanschluß 6 abgewandten Anschluß der Impedanz 5 gegen Masse angeordnet ist. Impedanz 5 und Glättungskondensator 7 bilden dabei einen Sieb- bzw. Glättungskreis zum Unterdrücken von einer als Gleichspannung ausgebildeten Versorgungsspannung am Spannungsversorgungsanschluß 6 überlagerten Wechselspannungsanteilen.

Im Betrieb der Tonsignalquelle 1 entnimmt diese der Spannungsversorgung eine Leistung, die zum Teil als Tonsignalleistung an die Tonwiedergabevorrichtung weitergeleitet wird. Dadurch fließt ein Strom vom Spannungsversorgungsanschluß 6 durch die Impedanz 5 in die Tonsignalquelle 1, der mit zunehmender Tonsignalleistung ansteigt. Durch diesen Strom wird in der Impedanz 5 (und gegebenenfalls in dem nicht dargestellten Innenwiderstand der Spannungsversorgung) eine Spannung hervorgerufen, um die sich die Versorgungsspannung an der Tonsignalquelle gegenüber dem Leerlauffall, in dem idealerweise von der Tonsignalquelle keine Leistung aufgenommen wird, verringert. Diese Verringerung erfolgt in einem durch die Tonsignalleistung und damit durch die Dimensionierung der Tonwiedergabevorrichtung vorgegebenen Maße, sofern der Anschluß zwischen der Tonsignalquelle und der Tonwiedergabevorrichtung über die Lautsprecherleitungen 3, 4 einwandfrei ist. Tritt jedoch im Bereich dieses Anschlusses 3, 4 oder auch der Tonwiedergabevorrichtung 2 eine Leitungsunterbrechung, ein Kurzschluß oder eine diesen extremen zustrebende Funktionsstörung auf, beispielsweise eine Widerstandserhöhung in den Lautprecherleitungen 3, 4, eine defekte Lötstelle, ein teilweiser Kurzschluß in den Lautsprechern oder dergleichen, weicht die Verminderung der Versorgungsspannung als Funktion der an der Tonsignalquelle 1 eingestellten Tonsignalleistung von ihrem Sollverlauf ab. Diese Abweichung kann als Indiz für das Vorliegen eines Defekts im Anschluß der Tonwiedergabevorrichtung 2 an die Tonsignalquelle 1 ausgewertet und in Form eines Fehlersignals dargestellt werden.

Die Schaltungsanordnung nach Fig. 1 weist weiterhin eine Steuerschaltung 8 auf, die wie die Tonsignalquelle 1 über die Impedanz 5 mit dem Spannungsversorgungsanschluß 6 zum Zuführen von Energie für den Betrieb verbunden ist. Parallel zum Glättungskondensator 7 ist ferner ein Widerstandsspannungsteiler aus zwei Widerständen 9, 10 angeordnet. Die Verbindung zwischen den Widerständen 9 und 10 bildet eine Anzapfung 11 des Widerstandsspannungsteilers 9, 10, von der aus eine Zenerdiode 12 gegen Masse geschaltet ist, die als Schutzelement gegenüber Spannungen dient. Die Anzapfung 11 bildet außerdem einen Spannungsmeßeingang der Steuerschaltung 8.

Eine Prüftonquelle 13 ist zur Energieversorgung ebenfalls über die Impedanz 5 an den Spannungsversorgungsanschluß 6 angeschlossen. Sie ist einerseits mit einer Summeranordnung 14 und andererseits über eine Leitung 15 mit der Tonsignalquelle 1 verbunden. Steuerleitungen 16 bzw. 17 führen von der Steuerschaltung 8 an die Tonsignalquelle 1 bzw. die Prüftonquelle 13.

Die Steuerschaltung 8 ist zum Steuern der Tonsignalquelle 1 an diese über die Steuerleitung 16 angeschlossen, über die übliche, hier nicht näher erläuterte Steuervorgänge vorgenommen werden können, bei einem Autoradio beispielsweise die Senderwahl, die Einstellung der Lautstärke, usw.. Die Steuerschaltung 8 enthält darüber hinaus erfindungsgemäß eine Spannungsmeßeinrichtung zur Messung der von der Spannungsversorgung am Spannungsversorgungsanschluß 6 über die Impedanz 5 gelieferten und über den Widerstandsspannungsteiler 9, 10 an der Anzapfung 11 abgegriffenen Versorgungsspannung. Bei exakter Betrachtung steht an der Anzapfung 11 eine gemäß dem Dimensionierungsverhältnis der Widerstände 9, 10 proportional verringerte Spannung zur Verfügung, was jedoch auf das Prinzip der Spannungsmessung keinen Einfluß hat.

Zur Erläuterung der erfindungsgemäßen Prüfung des Anschlusses der Tonwiedergabevorrichtung 2 an die Tonsignalquelle 1 in einem Beispiel ist in Fig. 2 ein Teil der Steuerschaltung 8 dargestellt, wie er in der Schaltungsanordnung nach Fig. 1 eingesetzt werden kann. Darin ist mit dem Bezugszeichen 18 die Spannungsmeßeinrichtung bezeichnet, der die Versorgungsspannung über die Anzapfung 11 zugeleitet wird. Weiterhin umfaßt die Steuerschaltung 8 nach Fig. 2 eine Vergleichseinrichtung 19, bestehend aus einem ersten Speicher 20 und einem zweiten Speicher 21 für von der Spannungsmeßeinrichtung 18 gemessene Werte der Versorgungsspannung, einer Komparatorstufe 22 sowie einem Referenzwertgeber 23. Eine Ablaufsteuerung 24, die bevorzugt auch Teil einer die Funktion der Tonsignalquelle 1 steuernden Anordnung sein kann, beispielsweise eines Microprozessors ist mit Steuerverbindungen 25, 26, 27 bzw. 28 mit der Spannungsmeßeinrichtung 18, dem ersten und dem zweiten Speicher 20, 21 und der Komparatorstufe 22 verbunden. Ferner bestehen Verbindungen 29, 30, 31, 32 für die gemessenen Werte der Versorgungsspannung zwischen der Spannungsmeßeinrichtung 18 und dem ersten Speicher 20, der Spannungsmeßeinrichtung 18 und dem zweiten Speicher 21, dem ersten Speicher 20 und der Komparatorstufe 22 bzw. dem zweiten Speicher 21 und der Komparatorstufe 22. Eine weitere Verbindung 33 besteht zwischen der Komparatorstufe 22 und dem Referenzwertgeber 23 zum Zuführen eines den vorgegebenen Betrag für die Abweichung der Werte der Versorgungsspannung bei den vorzunehmenden Messungen darstellenden Signals. Ein Anschluß 171 der Komparatorstufe 22, der Teil der Steuerleitung 17 ist, dient zur Abgabe eines Fehlersignals von der Komparatorstufe 22.

In Fig. 2 nicht dargestellt ist die Leistungseinstelleinrichtung zum Einstellen der von der Tonsignalquelle 1 an die Tonwiedergabevorrichtung 2 abzugebenden Tonsignalleistung, da diese in üblicher Weise aufgebaut ist. Zur Durchführung der Prüfung des Anschlusses der Tonwiedergabevorrichtung 2 in der erfindungsgemäßen Weise wird über diese Leistungseinstelleinrichtung die Tonsignalquelle zunächst auf einen ersten, vorgegebenen Wert der Tonsignalleistung eingestellt. Zum Erreichen definierter Tonsignalleistungen wird dabei bevorzugt von der Steuerschaltung 8 über die Steuerleitung 17 die Prüftonquelle 13 zum Einspeisen einer Prüfschwingung über die Leitung 15 in die Tonsignalquelle 1 angesteuert. So werden unkontrollierte Leistungsschwankungen aufgrund nicht steuerbarer Schwankungen anderer von der Tonsignalquelle 1 verfügbarer Tonsignale, beispielsweise Antennensignale, vermieden.

Nach Einstellung des ersten, vorgegebenen Wertes der Tonsignalleistung stellt sich durch den aus der Spannungsversorgung über den Spannungsversorgungsanschluß 6 entnommenen Strom und die Impedanz 5 ein erster gemessener Wert der Versorgungsspannung ein, der, gesteuert durch die Ablaufsteuerung 24, über die Verbindung 29 in den ersten Speicher 20 geleitet und dort abgespeichert wird. Anschließend wird von der Ablaufsteuerung 24 über die Leistungseinstelleinrichtung die Tonsignalquelle 1 auf einen zweiten, vorgegebenen Wert der Tonsignalleistung eingestellt und in entsprechender Weise zu dem ersten gemessenen Wert der Versorgungsspannung ein zweiter gemessener Wert durch die Spannungsmeßeinrichtung 18 erfaßt. Dieser wird über die Verbindung 30 in den zweiten Speicher 21 eingespeist. In der Komparatorstufe 22 wird dann die Differenz der in den Speichern 20 und 21 gespeicherten Meßwerte der Versorgungsspannung gebildet. Diese Differenz wird mit dem einen vorgegebenen Betrag repräsentierenden Signal vom Referenzwertgeber, zugeführt über die Verbindung 33, verglichen. Wird der vorgegebene Betrag durch die genannte Differenz überschritten, kann dies als Anzeichen für einen zumindest teilweisen Kurzschluß in dem Anschluß der Tonwiedergabevorrichtung 2 oder in dieser selbst ausgewertet werden; wird dagegen der vorgegebene Betrag durch die genannte Differenz unterschritten, stellt sich dies als Anzeichen für eine Leitungsunterbrechung in der Tonwiedergabevorrichtung 2 oder ihrem Anschluß dar. In beiden Fällen wird über den Anschluß 171 ein Fehlersignal ausgegeben. Dieses Fehlersignal kann für beide Fehlerarten einheitlich, jedoch auch unterschiedlich sein und damit in der Prüftonquelle 13 die Ausgabe eines akustischen Signals für beide Fehlerfälle in gleicher oder auch in unterschiedlicher Weise veranlassen. Die Prüftonquelle 13 dient somit auch zur Formung dieses akustischen Signals und ist zu dessen Ausgabe mit der Summeranordnung 14 verbunden.

Durch die Auswertung der beschriebenen Differenz zweier Meßwerte der Versor gungsspannung in der Komparatorstufe werden Schwankungen der Absolutwerte der Versorgungsspannung, beispielsweise hervorgerufen durch unterschiedliche Ladezustände eines die Spannungsversorgung bildenden Kraftfahrzeugakkumulators, in ihrem Einfluß auf die beschriebene Prüfung wirksam eliminiert. Zur weiteren Vermeidung nicht zutreffender Fehlersignale kann um den vorgebenen Betrag ein Toleranzbereich vorgesehen sein, innerhalb dessen die beschriebene Differenz der Meßwerte als zulässig erkannt wird. Für eine präzisere Fehlerbestimmung kann außerdem die beschriebene Prüfung für jeden Lautsprecher der Tonwiedergabevorrichtung 2 getrennt durchführbar sein.

Eine besonders vorteilhafte und aufwandsarme Anordnung der beschriebenen, erfindungsgemäßen Schaltungsanordnung ergibt sich dann, wenn im die Tonsignalquelle 1 und die Tonwiedergabevorrichtung 2 vorhandenen Gerät bereits eine Überwachungseinrichtung für die Versorgungsspannung vorhanden ist, mit der deren Absolutwert zur Sicherstellung einer ausreichenden Energieversorgung für die Tonsignalquelle und die Tonwiedergabevorrichtung überwacht wird. Diese Einrichtung kann dann sehr kostengünstig mit der Spannungsmeßeinrichtung 18 verknüpft werden; gegebenenfalls kann die Spannungsmeßeinrichtung 18 Teil dieser Überwachungseinrichtung sein.

## Patentansprüche

1. Schaltungsanordnung zum Prüfen des Anschlusses einer Tonwiedergabevorrichtung (2) an eine Tonsignalquelle (1), der über eine Impedanz (5) eine Versorgungsspannung aus einer Spannungsversorgung zuführbar ist und an die die Tonwiedergabevorrichtung (2) angeschlossen ist, mit
- einer Leistungseinstelleinrichtung zum Einstellen der von der Tonsignalquelle (1) an die Tonwiedergabevorrichtung (2) abzugebenden Tonsignalleistung,
- einer Spannungsmesseinrichtung (18) zur Messung der von der Spannungsversorgung über die Impedanz (5) gelieferten Versorgungsspannung in Abhängigkeit von der Tonsignalleistung, auf die die Tonsignalquelle (1) eingestellt ist,
- und einer Vergleichseinrichtung (19) zum Vergleichen der gemessenen Werte der Versorgungsspannung für zwei verschiedene vorgegebene Werte der Tonsignalleistung und zum Abgeben eines Fehlersignals, falls die gemessenen Werte der Versorgungsspannung nicht um einen vorgegebenen Betrag voneinander abweichen.

2. Schaltungsanordnung nach Anspruch 1, **dadurch gekennzeichnet, dass** die Leistungsstelleinrichtung, die Spannungsmesseinrichtung (18) und die Vergleichseinrichtung (19) Teile einer Steuerschaltung (8) für die Steuerung des Betriebs der Tonsignalquelle (1) sind.

3. Schaltungsanordnung nach Anspruch 2, **dadurch gekennzeichnet, dass** die Leistungsstelleinrichtung durch einen in der Steuerschaltung vorhandenen Lautstärkesteller gebildet ist.

4. Schaltungsanordnung nach Anspruch 1, 2 oder 3, **gekennzeichnet durch** eine Einrichtung zum Abgeben des Fehlersignals als akustisches Signal.

5. Schaltungsanordnung nach Anspruch 4, **dadurch gekennzeichnet, dass** die Einrichtung zum Abgeben des Fehlersignals als akustisches Signal eine Summeranordnung (14) umfasst.

6. Schaltungsanordnung nach einem der vorausgehenden Ansprüche, **dadurch gekennzeichnet, dass** eine Prüftonquelle (13) vorgesehen ist zum Einspeisen einer Prüfschwingung in die Tonsignalquelle (1) und dass von der Tonsignalquelle (1) für die Messung der Versorgungsspannung ein auf der Prüfschwingung beruhendes Tonsignal mit einer vorgebbaren Tonsignalleistung an die Tonwiedergabevorrichtung (2) abgebbar ist.

7. Schaltungsanordnung nach Anspruch 6 in Verbindung mit den Ansprüchen 4 oder 5, **dadurch gekennzeichnet, dass** die Prüftonquelle (13) von der Einrichtung zum Abgeben des Fehlersignals als akustisches Signal umfasst ist.

8. Schaltungsanordnung nach einem der vorausgehenden Ansprüche, **dadurch gekennzeichnet, dass** die Tonwiedergabevorrichtung (2) wenigstens einen Lautsprecher umfasst und die Messung der Versorgungsspannung für jeden Lautsprecher gesondert vornehmbar ist.

## Claims

1. Circuit arrangement for testing the connection of an audio reproduction apparatus (2) to an audio signal source (1) which can be supplied with a supply voltage from a voltage supply via an impedance (5) and has the audio reproduction apparatus (2) connected to it, having
- a power adjustment device for setting the audio signal power to be sent from the audio signal source (1) to the audio reproduction apparatus (2),
- a voltage measurement device (18) for measuring the supply voltage, delivered by the voltage supply via the impedance (5), as a function of the audio signal power to which the audio signal source (1) has been set,
- and a comparison device (19) for comparing the measured values of the supply voltage for two different prescribed values of the audio signal power and for sending an error signal if the measured values of the supply voltage do not differ from one another by a prescribed amount.

2. Circuit arrangement according to Claim 1, **characterized in that** the power adjustment device, the voltage measurement device (18) and the comparison device (19) are parts of a control circuit (8) for controlling the operation of the audio signal source (1).

3. Circuit arrangement according to Claim 2, **characterized in that** the power adjustment device is formed by a volume control which is provided in the control circuit.

4. Circuit arrangement according to Claim 1, 2 or 3, **characterized by** a device for sending the error signal as an audible signal.

5. Circuit arrangement according to Claim 4, **characterized in that** the device for sending the error signal as an audible signal comprises a buzzer arrangement (14).

6. Circuit arrangement according to one of the preceding claims, **characterized in that** a test audio source (13) is provided for feeding a test oscillation into the audio signal source (1), and **in that** the audio signal source (1) is able to send an audio signal which is based on the test oscillation and has a prescribable audio signal power to the audio reproduction apparatus (2) in order to measure the supply voltage.

7. Circuit arrangement according to Claim 6 in conjunction with Claim 4 or 5, **characterized in that** the test audio source (13) is included in the device for sending the error signal as an audible signal.

8. Circuit arrangement according to one of the preceding claims, **characterized in that** the audio reproduction apparatus (2) comprises at least one loudspeaker, and the supply voltage can be measured separately for each loudspeaker.

## Revendications

1. Circuit permettant de contrôler le raccordement d'un dispositif de reproduction sonore (2) à une source de signaux sonores (1), auquel il est possible d'appliquer, par l'intermédiaire d'une impédance (5), une tension d'alimentation provenant d'une alimentation en tension et sur lequel le dispositif de reproduction sonore (2) est raccordé, comprenant
- un dispositif de réglage de la puissance permettant de régler la puissance des signaux sonores à délivrer par la source de signaux sonores (1) au dispositif de reproduction sonore (2),
- un système de mesure de tension (18) permettant de mesurer la tension d'alimentation délivrée par l'alimentation en tension à travers l'impédance (5) en fonction de la puissance des signaux sonores sur laquelle la source de signaux sonores (1) est réglée,
- et un dispositif de comparaison (19) permettant de comparer les valeurs de mesure de la tension d'alimentation pour deux valeurs différentes données de la puissance des signaux sonores et permettant de délivrer un signal d'erreur, dans le cas où les valeurs de mesure de la tension d'alimentation ne diffèrent pas entre elles d'un montant donné.

2. Circuit selon la revendication 1 **caractérisé par le fait que** le dispositif de réglage de la puissance, le système de mesure de tension (18) et le dispositif de comparaison (19) font partie d'un circuit de commande (8) permettant de contrôler le fonctionnement de la source de signaux sonores (1).

3. Circuit selon la revendication 2 **caractérisé par le fait que** le dispositif de réglage de la puissance est constitué par un régulateur du volume sonore existant dans le circuit de commande.

4. Circuit selon la revendication 1, 2 ou 3 **caractérisé par** un dispositif permettant d'émettre un signal d'erreur sous la forme de signal acoustique.

5. Circuit selon la revendication 4 **caractérisé par le fait que** le dispositif permettant d'émettre le signal d'erreur en tant que signal acoustique comporte un dispositif vibreur (14).

6. Circuit selon l'une des revendications précédentes **caractérisé par le fait qu'**il est prévu une source sonore de test (13) permettant d'injecter une oscillation de test dans la source de signaux sonores (1) et que la source de signaux sonores (1) peut, pour la mesure de la tension d'alimentation, délivrer au dispositif de reproduction sonore (2) un signal sonore reposant sur l'oscillation de test et ayant une puissance de signal sonore qui peut être déterminée au préalable.

7. Circuit selon la revendication 6 en relation avec les revendications 4 ou 5 **caractérisé par le fait que** la source sonore de test (13) est comprise dans le dispositif permettant d'émettre le signal d'erreur en tant que signal acoustique.

8. Circuit selon l'une des revendications précédentes **caractérisé par le fait que** le dispositif de reproduction sonore (2) comprend au moins un haut-parleur et que la mesure de la tension d'alimentation peut être faite séparément pour chaque haut-parleur.
